# Europäisches Patentamt

(19) **European Patent Office**

**Office européen des brevets**

(11) Veröffentlichungsnummer: **0 092 514**
**B1**

(12) ## EUROPÄISCHE PATENTSCHRIFT

(45) Veröffentlichungstag der Patentschrift:
29.01.86

(51) Int. Cl.⁴: **H 03 K 17/687**

(21) Anmeldenummer: **83810139.2**

(22) Anmeldetag: **07.04.83**

(54) Ansteuerschaltung für ein Festkörperelement.

(30) Priorität: **07.04.82 CH 2153/82**

(43) Veröffentlichungstag der Anmeldung:
**26.10.83 Patentblatt 83/43**

(45) Bekanntmachung des Hinweises auf die Patenterteilung:
**29.01.86 Patentblatt 86/5**

(84) Benannte Vertragsstaaten:
**AT CH DE FR GB IT LI NL SE**

(56) Entgegenhaltungen:
**FR - A - 2 418 576**

(73) Patentinhaber: **STANDARD TELEPHON UND RADIO AG, Friesenbergstrasse 75, CH-8055 Zürich (CH)**

(84) Benannte Vertragsstaaten: **CH LI**

(73) Patentinhaber: **International Standard Electric Corporation, 320 Park Avenue, New York New York 10022 (US)**

(84) Benannte Vertragsstaaten: **DE FR GB IT NL SE AT**

(72) Erfinder: **Hochreutiner, Roger Maurice, Büelfeldweg 367, CH-8966 Lieli (CH)**
Erfinder: **Mattheus, Walter, 16 Frans Schollaertstraat, B-3200 Kessel Lo (BE)**

(74) Vertreter: **Bucher, Hans F., Laupenstrasse 15, CH-3008 Bern (CH)**

## Beschreibung

Die vorliegende Ansteuerschaltung betrifft eine Ansteuerschaltung für ein Festkörperelement gemäss dem Oberbegriff des ersten Anspruchs und deren Verwendung in einem elektronischen Relais.

Bei für hohe zu schaltende Spannungen ausgelegten elektronischen Relais, bei denen der die hohe Spannung schaltende Teil auf einer integrierten Schaltung hergestellt werden soll, muss zwischen den elektronischen Schaltstrecken und dem Steuereingang des Relais eine galvanische Trennung vorhanden sein. Es ist bekannt, diese galvanische Trennung mittels opto-elektronischer Koppler oder Transformatoren zu erreichen. Weder opto-elektronische Koppler noch Transformatoren können aber zusammen mit dem die hohe Spannung schaltenden Teil des Relais auf einem einzigen Chip integriert werden, wie die bisherige MOS-Technik zeigt.

Eine galvanische Trennung zwischen dem die hohe Spannung schaltenden Teil und dem Steuereingang des elektronischen Relais ist jedoch sehr wichtig bei integrierter Bauweise, weil die hohe Spannung am Relaisausgang den Eingangsteil des Relais zerstören oder mindestens ein unbeabsichtigtes Schalten des Relais bewirken kann. Die galvanische Trennung zwischen Steuereingang und dem schaltenden Teil eines Relais ist in manchen Anwendungsfällen erwünscht oder erforderlich, z.B. bei Teilnehmerleitungs-Anschlussschaltungen in der Fernsprechtechnik, bei denen der schaltende Teil des Relais erdfrei sein sollte.

Aus dem US-Pat. Nr. 4170740 ist ein integrierbares elektronisches Relais bekannt, dessen Eingang und Ausgang galvanisch getrennt sind. Die galvanische Trennung erfolgt durch Kondensatoren zwischen einer Steuerschaltung mit einem DC/DC-Wandler und einer Treiberschaltung mit einem EXCLUSIV-ODER-Tor, das nur auf gegenphasige Steuersignale anspricht, und durch die Gatterkapazitäten von den Lastkreis schaltenden MOS-Transistoren zwischen dem Lastkreis und der logischen Schaltung. Dieses Relais erfüllt die Bedingung der Integrierbarkeit ohne Probleme, es ist jedoch im gesperrten Zustand nicht hinreichend störspannungsfest. Dies rührt daher, dass die komplementären MOS-Transistoren im Lastkreis zwar durch eine positive Vorspannung einwandfrei in den leitenden Zustand geschaltet werden, dass hingegen die Umschaltung in den gesperrten Zustand nur durch Wegnahme dieser Vorspannung erfolgt. Daraus resultiert neben unterschiedlichen Zeitkonstanten für Ein- und Ausschalten ein hochohmiger Zustand für die Gatterelektroden im ausgeschalteten Zustand, so dass die Möglichkeit besteht, dass die Gatterkapazitäten durch Störspannungen aus dem Last- oder dem Steuerkreis aufgeladen werden, was zu einem unbeabsichtigten Schalten führen kann.

Es ist nun Aufgabe der Erfindung, eine Schaltungsanordnung für ein integrierbares elektronisches Relais anzugeben, das die oben erwähnten Nachteile nicht aufweist und insbesondere in beiden Schaltzuständen die gleiche Störspannungsfestigkeit aufweist.

Gelöst wird diese Aufgabe durch die im Kennzeichen des ersten Anspruch angegebenen Merkmale. Vorteilhafte Ausführungsformen können den abhängigen Ansprüchen entnommen werden.

Ausführungsbeispiele der Erfindung werden nun anhand der Zeichnung näher erläutert. In der Zeichnung zeigt:

Die Fig. 1-3 Schaltbilder von asymmetrischen MOS-Schaltern zur Erklärung der prinzipiellen Arbeitsweise von solchen Schaltern;

die Fig. 4 ein Schaltbild eines symmetrischen MOS-Schalters in der einfachsten Form;

die Fig. 5 ein Schaltbild der Treiberschaltung eines erfindungsgemässen integrierbaren elektronischen Relais;

die Fig. 6 ein Schaltbild der Steuerschaltung des elektronischen Relais nach Fig. 5; und

die Fig. 7 ein Schaltbild einer gegenüber Fig. 5 vereinfachten Ausführungsform der Treiberschaltung für ein elektronisches Relais.

Beim vorliegenden elektronischen Relais werden, wie beim oben erwähnten Patent, Kapazitäten für die galvanische Trennung benutzt. Die Ansteuerung erfolgt über DC/DC-Wandler und als Lastkreisschalter werden MOS-Transistoren mit Doppeldiffusion, d.h. DMOS-Transistoren mit einer hohen Durchbruchspannung von ca. 400 V benützt, wie es für einen breiten Einsatz eines elektronischen Relais notwendig ist. Die Technik der Doppeldiffusion zur Erreichung hoher Durchbruchsspannungen wurde von Dr Plumer, Standford University in IEEE Journal Solid State Circuits, Bd. SC-11, Dez. 1976, S. 809-817 beschrieben.

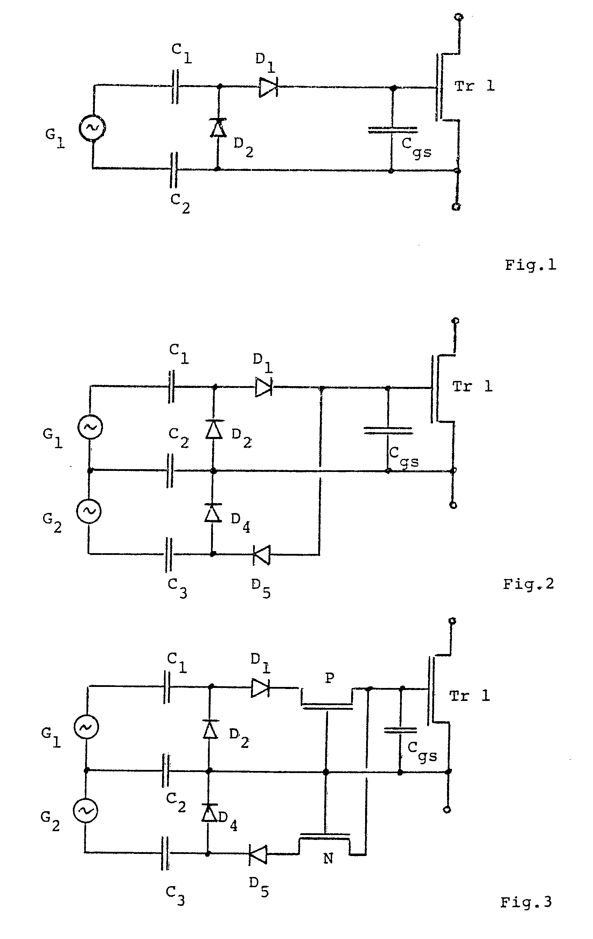

Der in Fig. 1 gezeigte DC/DC-Wandler ist eine klassische, kapazitiv gekoppelte Spannungsverdoppelungsschaltung mit einem Wechselspannungsgenerator $G_1$, Kapazitäten $C_1$ und $C_2$, Dioden $D_1$ und $D_2$ und einem Ladekondensator $C_{gs}$, welcher hier als separate Kapazität eingezeichnet ist, in Wirklichkeit aber die Gatter/Quellen-Kapazität eines als Schalttransistor arbeitenden DMOS-Transistors $Tr_1$ ist. Diese Schaltung kann die Kapazität $C_{gs}$ auf das Doppelte des Spitzenwertes der Generatorspannung minus den Spannungsabfällen über den Dioden $D_1$ und $D_2$ aufladen.

Ein entscheidendes Merkmal jedes konventionellen Relais ist dessen hohe Störspannungsfestigkeit. Diese Forderung muss natürlich auch an ein elektronisches Relais gestellt werden. Um dies zu erreichen, müsste der MOS-Schalter eine niedere Eingangsimpedanz haben, was z.B. mittels eines Widerstandes zwischen Gatter und Quelle erreicht werden könnte. Das wäre aber der Forderung nach hoher Treiberspannung bei kleiner Treiberleistung im durchgeschalteten Zustand des MOS-Schalters diametral zuwiderlaufend.

Um dies zu umgehen, bleibt nur die Möglichkeit, den DMOS-Transistor $Tr_1$ umgekehrt vorzuspannen, d.h. seine Kapazität $C_{gs}$ aus einer niederohmigen Quelle mit einer Ladung von entgegengesetzter Polarität zu versehen. Zu diesem Zweck ist in Fig. 2 ein zweiter DC/DC-Wandler mit einem zweiten Wechselspannungsgenerator $G_2$, einem Kondensator $C_3$ und Dioden $D_4$ und $D_5$ vorgesehen, welcher Wandler eine Spannung mit einer zu jener des ersten DC/DC-Wandlers umgekehrten Polarität liefert. Bei dieser Schaltung schliessen allerdings die Dioden der einen Spannungsverdoppelungsschaltung die Ausgangsspannung der jeweils andern kurz. Dadurch ist die maximale Ladespannung an $C_{gs}$ auf $\pm$ 1,5 V beschränkt, d.h. auf den Spannungsabfall über den jeweiligen zwei in Serie geschalteten Dioden.

Um diese Beschränkung zu umgehen, sind bei der Schaltung nach Fig. 3 zwei komplementäre MOS-Transistoren P und N in die Leitungen zur Kapazität $C_{gs}$ geschaltet, die den jeweils störenden DC/DC-Wandler abtrennen.

Es kann gezeigt werden, dass diese Schaltung eine ausgezeichnete Störspannungsfestigkeit besitzt. Wenn der nichtverwendete Zweig des DC/DC-Wandlers hochohmig ist, kann eine Geräuschspannungsspitze mit positiver Polarität an der Quelle des MOS-Transistors $Tr_1$ die Ladung an $C_{gs}$ nicht verändern. Wenn die Ladung in $C_{gs}$ am Gatter von $Tr_1$ positives Vorzeichen aufweist, fliesst ein Strom durch die beiden oberen Koppelkapazitäten $C_1$ und $C_2$. Eine Geräuschspannungsspitze negativer Polarität bewirkt einen Stromfluss aus den Koppelkapazitäten in die Kapazität $C_{gs}$ und damit eine noch stärkere positive Aufladung von $C_{gs}$, was zulässig ist. Mit Hilfe einer Zenerdiode über $C_{gs}$ kann diese Schaltung gegen Überspannung geschützt werden. In dieser Form erträgt die Schaltung die von der verwendeten Technologie her mögliche maximale Spannung von $\pm$ 400 V. Die einzige Grenze ergibt sich aus der zulässigen Verlustleistung, weil die Impedanz der Koppelkapazitäten mit steigender Frequenz fällt.

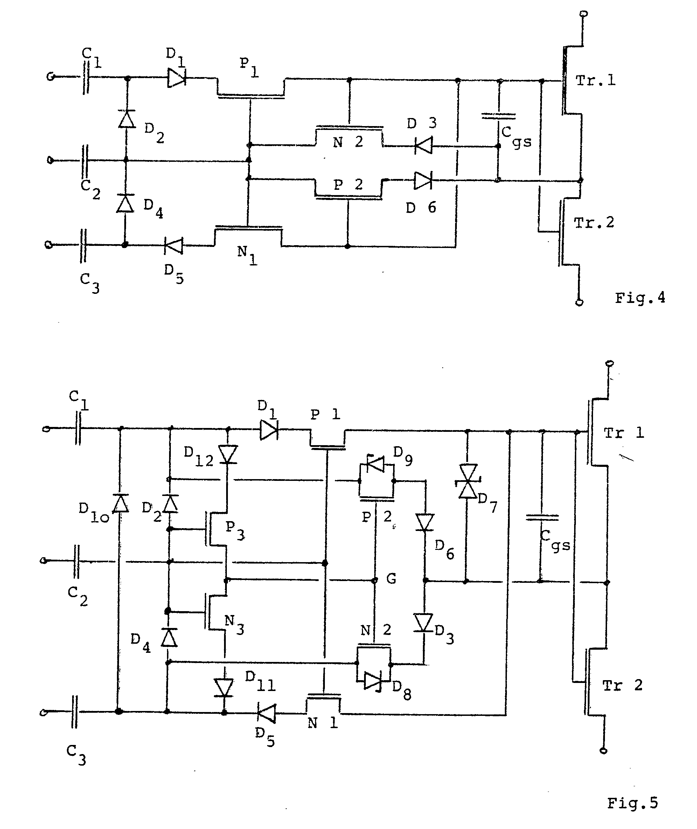

Bei einer praktischen Verwendung der Schaltung nach Fig. 3 wird die Quellenelektrode des MOS-Transistors $Tr_1$ z.B. mit einer Teilnehmer-Leitung verbunden, die ihrerseits über irgendwelche komplexe kapazitive oder auch resistive Netzwerke mit Erde verbunden ist. Dies kann die mittlere Kopplungskapazität praktisch kurzschliessen und daher die Ausgangsspannung der DC/DC-Wandler drastisch verringern. Um dies zu umgehen, muss in die mittlere Leitung der Schaltung nach Fig. 3 pro Wandlerpolarität eine Diode eingefügt werden, die in Abhängigkeit von der an $C_{gs}$ erforderlichen Polarität geschaltet werden muss. Es ergibt sich dann die in Fig. 4 gezeigte Schaltung mit den gegenüber der Schaltung nach Fig. 4 im Schalterteil mit einem Paar von komplementären MOS-Transistoren $Tr_1$ und $Tr_2$ anstelle des bisher einzigen MOS-Transistors $Tr_1$ ausgerüstet, um Wechselstromsignale schalten zu können.

Es wurde bereits festgestellt, dass eine einwandfreie Arbeitsweise in einem Umfeld mit Störspannungen dann erreicht wird, wenn der unbenutzte Treiberzweig hochohmig ist. Wäre das bei einer positiven Ladung von $C_{gs}$ nicht der Fall, würde eine Störspannungsspitze den MOS-Transistor $N_1$ im unteren Wandler zum Leiten bringen und die Ladung in $C_{gs}$ würde verändert.

Es hat sich nun gezeigt, dass es bei einer praktischen Realisation der Schaltung leichter ist, für einen der Schaltzustände (z.B. für MOS-Schalter ein) den mittleren und den untersten Zweig in Gegenphase zum oberten Zweig zu betreiben und für den andern Schaltzustand die beiden oberen Zweige in Gegenphase zum untersten Zweig zu betreiben. Dies ist bei der Schaltung nach Fig. 5 realisiert.

Bei der Schaltung nach Fig. 5 bilden die Elemente $D_2$, $D_4$, $P_3$ und $N_3$, $D_{11}$ und $D_{12}$ eine Hilfsstromquelle, welche die Kapazitäten der Gatter $P_2$ und $N_2$ (Knoten G) während jeder Halbperiode aufladen. Diese Ladung bleibt dynamisch festgelegt, bis die Ansteuerungsbedingungen geändert werden. Der obere Wandler besteht nun aus den Elementen $D_1$, $P_1$, $D_3$, $N_2$, $D_{10}$ und der untere Wandler aus den Elementen $P_2$, $D_6$, $N_1$, $D_5$ und $D_{10}$. Die Diode $D_{10}$ stellt eine wirksame Umladung der Kapazitäten $C_1$ und $C_3$ durch Überbrücken der Dioden $D_2$ und $D_4$ sicher. Es ist ersichtlich, dass die Vorspannung von $P_2$ und $N_2$ wegen der Impedanz von $P_1$ (und $N_1$) während des Ladevorganges von $C_{gs}$ weitgehend unabhängig ist von der Spannung an $C_{gs}$. Eine anfänglich an $C_{gs}$ vorhandene Spannung Null reduziert die obige Vorspannung nicht. Es ist auch zu bemerken, dass keine Zeitkonstanten wirksam sind. Wenn die Ansteuerung ändert von z.B. $C_1 = \overline{C_2} = \overline{C_3}$ auf $C_3 = \overline{C_2} = \overline{C_1}$, ändert die Hilfsstromquelle sofort auch, und zwar für beide Änderungsrichtungen gleich rasch.

Das Umschalten geschieht extrem rasch. Es soll einmal angenommen werden, $C_{gs}$ sei positiv geladen. Sobald $C_1 = \overline{C_2} = \overline{C_3}$ auf $C_3 = \overline{C_2} = \overline{C_1}$ wechselt, wechselt auch die Polarität am Knoten G und $P_3$, $N_2$ sind gesperrt, während $P_2$, $N_3$ leitend sind. Die Kapazität $C_{gs}$ entlädt sich während der negativen Halbperiode an $C_3$ über $N_1$, $D_5$, $D_{10}$, $P_2$, $D_6$ mit einem Anfangsspitzenstrom von 6 mA (8 V/3 Dioden + 1 k$\Omega$), so dass die Entladung von 8 V hinunter auf 2,25 V (3 Dioden) nicht in den Pumpkreis gepumpt werden muss. Dank der Steuerung des Knotens G sind alle Ladepfade eindeutig, was ein rasches Umschalten sicherstellt.

Im Folgenden soll nun die Störempfindlichkeit dieser Schaltung etwas näher untersucht werden. In Abhängigkeit von der Polarität der Ladung an $C_{gs}$ und von der Polarität des Störsignals lassen sich folgende Fälle unterscheiden.

a) $C_{gs}$ ist in Bezug auf die Quellenelektrode des Schalters positiv geladen, der MOS-Schalter ist eingeschaltet. $P_3$ und $P_1$ sind leitend für jede positive Halbwelle der Treiberspannung an $C_1$. Die Gatter am Knoten G ($P_2$, $N_2$) sind positiv geladen, dabei ist $P_2$ gesperrt und $N_2$ leitend.

aa) Positive Störspannung: Der Störstrom fliesst über $D_3$, $N_2$, $C_3$ und dann auch über $D_{10}$, $C_1$ und $D_4$, $C_2$. Wenn die Spannung über $N_2$ 10 V übersteigt, beginnt die Zenerdiode $D_8$ zu leiten und stellt sicher, dass die Summe der Spannungen über $N_2$ und $C_{gs}$ die Durchbruchspannung von $N_1$ nicht übersteigt. Die Ladung an $C_{gs}$ ändert dabei nicht. Der Spitzenwert des Störstromes ist hauptsächlich bestimmt durch die Impedanz aller parallelgeschalteten Koppelkapazitäten und ist ungefähr 72 mA bei einer Störspannung von 400 V bei 1 MHz.

ab) Negative Störspannung: Alle Elemente bleiben wie oben. Es fliesst ein Strom über $C_1$, $D_1$, $P_1$ nach $C_{gs}$. Die Ladung an $C_{gs}$ wird durch eine Zenerdiode $D_7$ begrenzt. Wenn die Spannung über $P_1$ plus die Spannung an $C_{gs}$ den Wert 10 V übersteigt, beginnt die Zenerdiode $D_9$ zu leiten und übernimmt den zusätzlichen Strom. Dabei fliesst auch Strom durch die zu $C_1$ parallel liegenden Kapazitäten $C_2$ und $C_3$. Die Ladung von $C_{gs}$ ändert dabei nicht. Der Strom hat ebenfalls einen Maximalwert von 72 mA bei 400 V und 1 MHz.

In beiden Fällen fällt der Störstrom linear mit der Frequenz. Ebenfalls in beiden Fällen werden, wenn die Ladung am Knoten G auf Null fällt, z.B. während einer sehr lang dauernden Büschelstörung, alle mit G verbundenen Elemente gesperrt, die Ladung an $C_{gs}$ ändert sich jedoch nicht, natürlich mit Ausnahme der durch den normalen Leckstrom bedingten Änderung, und der ganze Störstrom fliesst durch Zenerdioden.

b) $C_{gs}$ ist negativ geladen, der MOS-Schalter ist ausgeschaltet. $N_3$ ist leitend für jede negative Halbwelle der Treiberspannung an $C_3$. Der Gatterknoten G ist negativ. $P_3$ und $N_2$ sind gesperrt, $P_2$ ist leitend.

ba) Positive Störspannung: Der Störstrom fliesst über $C_{gs}/D_7$, $N_1$, $D_5$ und bei höheren Strömen als 2 mA über $D_3$ und $D_8$ und parallel über alle Koppelkapazitäten.

bb) Negative Störspannung: Der Störstrom fliesst über $P_2$, $D_6$ und bei Strömen über 2 mA über $D_9$ und $D_6$.

In beiden Fällen bleibt die Ladung von $C_{gs}$ unverändert.

Es folgen nun noch einige Angaben zur Dimensionierung der Treiberschaltung nach Fig. 5. Die Gatterkapazität $C_{gs}$, die wie schon erwähnt, kein getrenntes Element ist, wie gezeichnet, hat einen Wert von ca. 100 pF. Dies bedingt Koppelkapazitäten von ungefähr 10-15 pF für $C_1$ und $C_3$, welche als einzige Pumpstrom in die Gatterkapazität $C_{gs}$ zu liefern haben. Die Kapazität $C_2$ kann den geringen Wert von 1 pF haben, da sie nur Pumpstrom für die Gatterkapazitäten der Hilfsgatter $P_3$ und $N_3$, wie auch $P_1$ und $N_1$ liefern muss, die je einen Wert von etwa 1/4 pF haben.

Die Zenerdioden $D_8$, $D_9$ und $D_7$ müssen Zenerspannungen haben, deren Summe kleiner ist als die Durchbruchspannung von $N_1$ bzw. $P_1$, d.h. etwa 18 V. Eine Aufteilung mit 8 V für $D_7$ und je 9 V für $D_8$ und $D_9$ ist eine mögliche Lösung. In jedem Fall müssen aber die Spannungen von $D_8$ und $D_9$ höher sein als jene von $D_7$. Bei sehr starken Störspannungsspitzen werden die P- und N-Diffusionen vorwärts vorgespannt und der Störstrom fliesst je nach dessen Polarität entweder gegen Erde oder in die Speisequelle.

Der Widerstand aller Elemente in derem leitenden Zustand ist von zweitrangiger Bedeutung. Alle Dioden und metallischen Leitungen im Störstrompfad müssen jedoch mindestens einen Strom von 100 mA führen können.

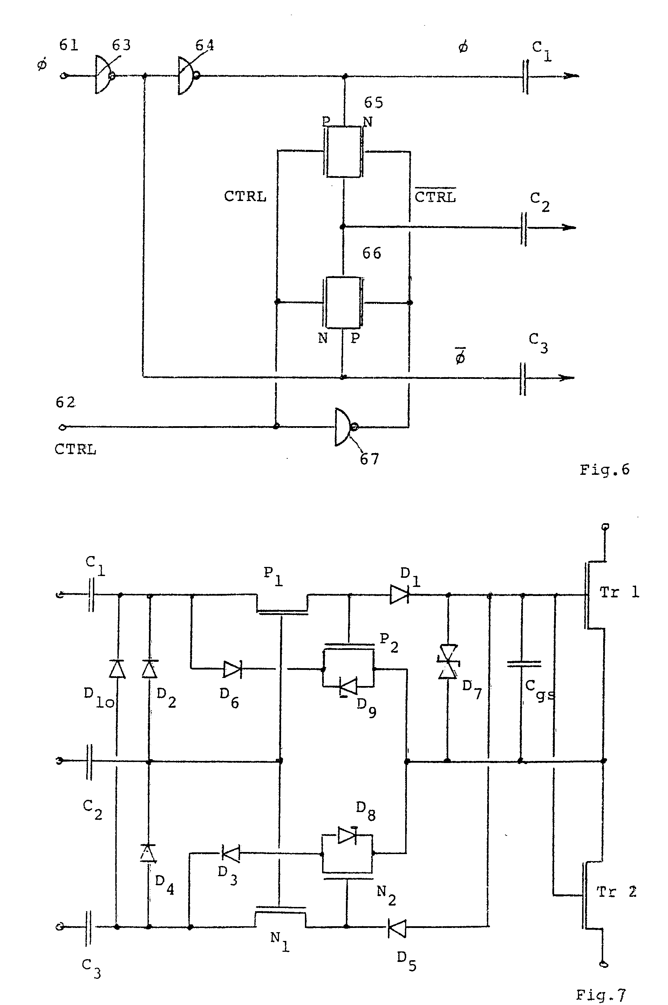

In Fig. 6 ist die zur Treiberschaltung nach Fig. 5 gehörige Steuerschaltung gezeigt. Sie besteht im wesentlichen aus zwei in Kaskade geschalteten invertierenden Leistungsverstärkern 63 und 64, welche in der Lage sei müssen, die notwendigen Pumpströme zu liefern, und aus einem Paar von Übertragungsgattern 65 und 66 mit komplementären Kanälen. An einem Eingang 61 liegt ein Oszillatorsignal mit einer Frequenz von z.B. 1 MHz und einer Amplitude von 5 $V_{pp}$ an, während am Eingang 62 ein Gleichstromsignal anliegt, um über ein invertierendes Tor 67 den Schaltzustand der MOS-Schalter am Ausgang der Treiberschaltung nach Fig. 5 zu steuern.

Fig. 7 zeigt eine vereinfachte Version der Schaltung nach Fig. 5. Die Hilfsstromquelle mit den Transistoren $P_3$ und $N_3$ ist weggelassen und der Knoten G ist mit dem Gatter der MOS-Schalters verbunden. Wegen der einfacheren Auslegung sind die Streukapazitäten der integrierten Schaltung kleiner, was verglichen mit der Schaltung nach Fig. 5 bezüglich der Schaltzeiten eine Verbesserung ergibt.

Geräuschspannungsspitzen, welche an der Quellenelektrode des MOS-Schalters auftreten, haben die gleichen Wirkungen wie bei der früheren Schaltung, d.h. es ergeben sich praktisch keine Auswirkungen auf die Ladung der Gatter/Quellenkapazität $C_{gs}$ des MOS-Schalters und damit auf den Schaltzustand des Schalters.

Die Substrate der verschiedenen MOS-Transistoren sind mit den entsprechenden Quellenelektroden verbunden, z.B. in Fig. 5 mit den linken Anschlüssen der Transistoren $P_1$, $P_2$, $N_1$ bzw. $N_2$. Dank den mit diesen Transistoren in Serie geschalteten Dioden ist eine sichere Arbeitsweise dieser Elemente garantiert. Die Dioden $D_1$ und $D_5$ sind auf der rechten Seite der Transistoren $P_1$ bzw. $N_1$ angeordnet, so dass diese härter angesteuert werden können und dadurch die Transistoren $P_2$ bzw. $N_2$ wirksamer sperren können.

Die vorliegende Schaltung kann, wie in der Zeichnung gezeigt, in Verbindung mit einem integrierten Hochspannungsschalter verwendet werden, es könnte aber auch irgend ein anderes, getrennte Element mit hoher Eingangsimpedanz angesteuert werden. Es steht ein Signal von ± 8 V in 100 pF mit einer Anstiegszeit von 10 µs zur Verfügung. Die Spannungsfestigkeit beträgt ± 400 V und die Störspannungsfestigkeit ist grösser als 1000 V/µs.

## Patentansprüche

1. Monolithisch integrierte Ansteuerschaltung für ein Festkörperelement mit galvanischer Trennung zwischen deren Eingang und deren Ausgang mit einer Gegentakt-Wechselstromquelle, welche über zwei Eingangs-Seriekapazitäten ($C_2$, $C_3$) mit dem Eingang einer Gleichrichterschaltung mit mindestens vier Dioden verbunden ist, und mit einer mit dem Ausgang der Gleichrichterschaltung vorhandenen Ausgangs-Parallelkapazität ($C_{gs}$), dadurch gekennzeichnet, dass eine dritte Ein-

gangs-Seriekapazität (C$_2$) vorhanden ist, deren Eingang mit der genannten Quelle und deren Ausgang ebenfalls mit der Gleichrichterschaltung verbunden ist, welche erste (D$_1$, D$_3$, D$_4$, D$_2$, D$_{10}$) und zweite (D$_6$, D$_5$, D$_4$, D$_2$, D$_{10}$) Teile aufweist zur Erzeugung einer ersten bzw. zweiten Polarität des Ausgangssignales, wobei Steuermittel ermöglichen, die Ausgangskapazität (C$_{gs}$) mit der ersten oder zweiten Polarität aufzuladen.

2. Ansteuerschaltung nach Anspruch 1, dadurch gekennzeichnet, dass die Steuermittel Tormittel (65, 66) aufweisen, um den Eingang der dritten Seriekapazität (C$_2$) wahlweise mit dem Eingang der ersten (C$_1$) oder der zweiten (C$_3$) Seriekapazität zu koppeln, um die Ausgangskapazität (C$_{gs}$) mit gleicher und praktisch vernachlässigbarer Zeitverzögerung mit der ersten oder der zweiten Polarität aufzuladen.

3. Ansteuerschaltung nach Anspruch 2, dadurch gekennzeichnet, dass die Quellen/Senken-Pfade eines ersten Paares von komplementären MOS-Transistoren (P$_1$, N$_1$) in Serie mit Dioden (D$_1$, D$_5$) der Gleichrichterschaltung gekoppelt sind, um die erste (C$_1$) und die zweite (C$_3$) Seriekapazität mit der Ausgangskapazität zu koppeln, wobei die Gatterelektroden dieser Transistoren mit der dritten Seriekapazität (C$_2$) gekoppelt sind.

4. Ansteuerschaltung nach Anspruch 3, dadurch gekennzeichnet, dass in den Zweig mit der dritten Seriekapazität zwei gegensinnig gekoppelte Dioden (D$_3$, D$_6$) in Serie mit je einem MOS-Transistor eines zweiten Paares von komplementären MOS-Transistoren (P$_2$, N$_2$) eingefügt sind, welche Transistoren durch das Potential an der Ausgangskapazität (C$_{gs}$) gesteuert werden, um eine zu hohe Belastung der Ansteuerschaltung durch Elemente im Lastkreis des Festkörperelementes zu verhinden.

5. Ansteuerschaltung nach Anspruch 4, dadurch gekennzeichnet, dass die Schaltstrecken der zweiten MOS-Transistoren (P$_2$, N$_2$) durch je eine Zenerdiode (D$_9$, D$_8$) und die Ausgangskapazität (C$_{gs}$) durch eine Begrenzerdiode (D$_7$) oder zwei antiparallel geschaltete Zenerdioden gegen Überspannung geschützt sind.

6. Ansteuerschaltung nach Anspruch 5, dadurch gekennzeichnet, dass die Summe der Zenerspannung jeweils einer der Zenerdioden (D$_8$ bzw. D$_9$) und der Spannung der Begrenzerdiode (D$_7$) kleiner ist als die Durchbruchspannung der ersten MOS-Transistoren (P$_1$, N$_1$), damit deren Schaltstrecken gegen Überspannung geschützt sind.

7. Ansteuerschaltung nach Anspruch 6, dadurch gekennzeichnet, dass ein drittes Paar von komplementären MOS-Transistoren (P$_3$, N$_3$) vorhanden ist, um die Gatter/Quellen-Kapazität des zweiten Paares von MOS-Transistoren (P$_2$, N$_2$) während jeder Halbperiode des Signales der Wechselstromquelle aufzuladen.

8. Verwendung der Ansteuerschaltung nach einem der Ansprüche 1 bis 7 in einem elektronischen Relais, dadurch gekennzeichnet, dass das Festkörperelement aus einem Paar komplementärer MOS-Leistungstransistoren (Tr$_1$, Tr$_2$) besteht, und dass die Ausgangskapazität die Gatter/Quellenkapazität (C$_{gs}$) dieser Transistoren ist.

9. Verwendung nach Anspruch 8, dadurch gekennzeichnet, dass die MOS-Leistungstransistoren auf dem Substrat der Ansteuerschaltung integriert sind.

## Claims

1. Monolithically integrated control circuit for a semiconductor element provided with a galvanical isolation between its input and its output comprising a push-pull AC source connected via two input series capacitances (C$_1$, C$_3$) to the input of a rectifier circuit including at least four diodes and comprising an output parallel capacitance (C$_{gs}$) connected to the output of the rectifier circuit, characterized in that there is provided a third series capacitance (C$_2$) the input of which is connected to said source and the ouput of which is also connected to the rectifier circuit comprising first (D$_1$, D$_3$, D$_4$, D$_2$, D$_{10}$) and second (D$_6$, D$_5$, D$_4$, D$_2$, D$_{10}$) components to produce a first and a second, respectively, polarity of the output signal, control means allowing to charge the output capacitance with a first or a second polarity.

2. Control circuit according to Claim 1, characterized in that the control means comprise gate means (65, 66) to connect the input of the third series capacitance (C$_2$) selectively to the input of the first (C$_1$) or the second (C$_3$) series capacitance in order to charge the output capacitance with the first or the second polarity with the same and substantially negligible time lags.

3. Control circuit according to Claim 2, characterized in that the drain/source paths of a first pair of complementary MOS transistors (P$_1$, N$_1$) are connected in series with diodes (D$_1$, D$_5$) of the rectifier circuit in order to couple the first (C$_1$) and the second (C$_3$) series capacitances with the output capacitance, the gate electrodes of said transistors being coupled to said third series capacitance (C$_2$).

4. Control circuit according to Claim 3, characterized in that into the branch containing the third series capacitance there are inserted two oppositely connected diodes (D$_3$, D$_6$) each connected in series with an MOS transistor of a second pair of MOS transistors (P$_2$, N$_2$) which are controlled by the potential across the output capacitance (C$_{gs}$) in order to avoid an excessive load of the control circuit by elements in the load circuit of the semiconductor element.

5. Control circuit according to Claim 4, characterized in that each of the drain/source paths of the second MOS transistors (P$_2$, N$_2$) is protected against over-voltage by a zener diode (D$_9$, D$_8$) and the output capacitance (C$_{gs}$) is protected by a limiting diode (D$_7$) or by two oppositely connected zener diodes.

6. Control circuit according to Claim 5, characterized in that the sum of the zener voltage of one of the zener diodes (D$_8$ or D$_9$, respectively) and of the voltage of the limiting diode (D$_7$) is smaller

than the breakthrough voltage of the first MOS transistors ($P_1$, $N_1$) in order to protect their drain/source paths against over-voltage.

7. Control circuit according to Claim 6, characterized in that a third pair of complementary MOS transistors ($P_3$, $N_3$) is provided to charge the gate/source capacitance of the second pair of MOS-transistors ($P_2$, $N_2$) during each half-period of the signal of the AC source.

8. Application of the control circuit according to one of the Claims 1 to 7 in an electronic relay, characterized in that the semiconductor element consists of a pair of complementary power MOS transistors ($Tr_1$, $Tr_2$), and that the output capacitance consists of the gate/source capacitance ($C_{gs}$) of said transistors.

9. Application according to Claim 8, characterized in that the MOS power transistors are integrated on the substrate of the control circuit.

**Revendications**

1. Circuit de commande intégré monolithiquement pour un dispositif intégré pourvu d'une isolation galvanique entre son entrée et sa sortie comprenant une source alternative push-pull connectée, par l'intermédiaire de deux capacités d'entrée série ($C_1$, $C_3$) à l'entrée d'un circuit de redressement incluant au moins quatre diodes, ainsi qu'une capacité de sortie parallèle ($C_{gs}$) couplée aux bornes de sortie de ce circuit de redressement, caractérisé en ce qu'une troisième capacité d'entrée série ($C_2$) est également prévue, dont l'entrée est connectée à ladite source et la sortie est connectée à l'entrée du circuit de redressement, lequel incorpore des premiers ($D_1$, $D_3$, $D_2$, $D_4$, $D_2$, $D_{10}$) et des seconds ($D_6$, $D_5$, $D_4$, $D_2$, $D_{10}$) composants produisant respectivement des première et seconde polarités de sortie, des moyens de commande permettant de charger ladite capacité de sortie ($C_{gs}$) par ladite première ou ladite seconde polarité.

2. Circuit de commande selon la revendication 1, caractérisé en ce que les moyens de commande comprennent des moyens de portes (65, 66) pour connecter l'entrée de la troisième capacité d'entrée série ($C_2$), sélectivement avec l'entrée de la première ($C_1$) ou de la seconde ($C_3$) capacité d'entrée série, afin de charger la capacité de sortie ($C_{gs}$) par la première ou la seconde polarité, avec des temps de retard égaux et sensiblement négligeables.

3. Circuit de commande selon la revendication 2, caractérisé en ce que les trajets source/drain d'une première paire de transistors MOS complémentaires ($P_1$, $N_1$) sont connectés en série avec des diodes ($D_1$, $D_5$) du circuit de redressement, afin de connecter la première ($C_1$) et la seconde ($C_3$) capacité série à la capacité de sortie, les électrodes de grille de ces transistors étant couplées à la troisième capacité série ($C_2$).

4. Circuit de commande selon la revendication 3, caractérisé en ce que, dans la branche de la troisième capacité série, deux diodes ($D_3$, $D_6$) polarisées en opposition sont insérées, chacune connectée en série avec un transistor MOS d'une seconde paire de transistors MOS complémentaires ($P_2$, $N_2$) qui sont commandés par le potentiel aux bornes de la capacité de sortie ($C_{gs}$), afin d'éviter une charge excessive du circuit de commande par des éléments du circuit de charge du dispositif intégré.

5. Circuit de commande selon la revendication 4, caractérisé en ce que chacun des trajets de commutation des seconds transistors MOS ($P_2$, $N_2$) est protégé par une diode Zener ($D_9$, $D_8$) et la capacité de sortie ($C_{gs}$) est protégée par une diode limiteuse ($D_7$) ou deux diodes Zener connectées en opposition contre les surtensions.

6. Circuit de commande selon la revendication 5, caractérisé en ce que la somme de la tension de Zener de l'une des diodes Zener ($D_8$ ou $D_9$, respectivement) et de la tension de la diode limiteuse ($D_7$) est plus petite que la tension de claquage des premiers transistors MOS ($P_1$, $N_1$), afin de protéger leurs trajets de commutation contre les surtensions.

7. Circuit de commande selon la revendication 6, caractérisé en ce qu'une troisième paire de transistors MOS complémentaires ($P_3$, $N_3$) sont prévus afin de charger la capacité grille/source de la seconde paire de transistors MOS ($P_2$, $N_2$) durant chaque demi-période.

8. Application du circuit de commande selon l'une des revendications 1 à 7 dans un relais à l'état solide, caractérisée en ce que le dispositif intégré consiste en une paire de transistors de puissance MOS complémentaires ($Tr_1$, $Tr_2$) et en ce que la capacité de sortie consiste en la capacité grille/source de ces transistors.

9. Application selon la revendication 8, caractérisée en ce que les transistors de puissance MOS sont intégrés dans le substrat du circuit de commande.

Fig.1

Fig.2

Fig.3

Fig.4

Fig.5

Fig.6

Fig.7